# EUROPÄISCHE PATENTSCHRIFT

(11) **EP 1 624 597 B1**
(45) Veröffentlichungstag und Bekanntmachung des Hinweises auf die Patenterteilung: **24.09.2008**
(21) Anmeldenummer: 05105846.9
(22) Anmeldetag: 30.06.2005
(51) Int. Cl.: H04B 15/02

(54) **Sicherung in Serie mit einem Kondensator zur Vermeidung der Folgen eines Kurzschlusses in dem Kondensator**
Fuse in series with capacitor to avoid the consequences of a short circuit in the capacitor
Fusible en série avec un condensateur pour éviter les conséquences d'un court-circuit dans le condensateur

(30) Priorität: 06.08.2004 DE 102004038184
(43) Veröffentlichungstag der Anmeldung: 08.02.2006
(73) Patentinhaber: ROBERT BOSCH GMBH, 70442 Stuttgart (DE)
(72) Erfinder: Rummel, Michael, 77855, Achern-Oensbach (DE)

(56) Entgegenhaltungen:
- EP-A- 1 416 536
- [Online] 17. Juli 2004 (2004-07-17), Seiten 1-41, XP002357826 Gefunden im Internet: URL:http://web.archive.org/web/20040717071 549/http://www.epanorama.net/links/compone ntinfo.html> [gefunden am 2005-12-06]

## Beschreibung

Die Erfindung betrifft eine Vorrichtung zur Verringerung der Abstrahlung von Funkstörsignalen.

### Stand der Technik

Im Zusammenhang mit in Kraftfahrzeugen verwendeten elektronischen Steuergeräten ist es bereits bekannt, Folien-oder Keramikkondensatoren zur Verringerung von abgestrahlten Funkstörsignalen einzusetzen. Im Zuge der Miniaturisierung sind mittlerweile auch Keramikkondensatoren in SMD-Bauform verfügbar, die die benötigten Kapazitätswerte bereitstellen. Bei derartigen Keramikkondensatoren handelt es sich um Multilayer-Chipkondensatoren, die bei einer mechanischen Beanspruchung zu einem Ausfall neigen, wobei ein dauerhafter Kurzschluss auftreten kann. Dies kann bei Steuergeräten, bei denen der Keramikkondensator niederohmig direkt an die Klemme 30 oder die Klemme 15 des Kraftfahrzeugbordnetzes angeschlossen ist, zu einem Kurzschlussstrom führen, der eine thermische Zerstörung des Steuergerätes verursachen kann.

Weiterhin ist es bereits bekannt, eine Vorrichtung zur Verringerung der Abstrahlung von Funkstörsignalen vorzusehen, die eine Serienschaltung von zwei Kondensatoren aufweist. Bei einer derartigen Vorrichtung tritt bei einem Kurzschluss nur eines der Kondensatoren kein Kurzschlussstrom auf, der eine thermische Zerstörung des Steuergerätes bewirken kann. Jedoch wird durch den Einsatz einer Serienschaltung von zwei Kondensatoren die Gesamtkapazität verringert, was wiederum dazu führt, dass die Kapazitätswerte der Kondensatoren vergrößert werden müssen, um die gewünschte Verringerung der Abstrahlung von Störsignalen zu erreichen. Dies führt zu einer Vergrößerung der Bauform der Kondensatoren, wodurch der Platzbedarf der Vorrichtung steigt. Weiterhin nimmt durch die genannte Vergrößerung der Bauform der Kondensatoren das Risiko eines Keramikbruches weiter zu.

Aus der EP-A-1 414 536 ist eine Vorrichtung zur Abtrennung eines defekten Koppelkondensators in einer Spannungsversorgungsschaltung bekannt. Die Abtrennung erfolgt dabei mittels einer Sicherung, die in Reihe mit dem Koppelkondensator geschaltet ist.

### Vorteile der Erfindung

Eine Vorrichtung zur Verringerung der Abstrahlung von Funkstörsignalen mit den im Anspruch 1 angegebenen Merkmalen weist demgegenüber den Vorteil auf, dass im Falle eines Auftretens eines Fehlers mit permanentem Kurzschluss des Keramikkondensators das Widerstandselement verdampft, so dass eine thermische Zerstörung des jeweiligen an die Vorrichtung angeschlossenen Gerätes verhindert wird. Die Funktion des an die Vorrichtung angeschlossenen Gerätes kann dann trotz des Vorliegens eines Fehlers mit permanentem Kurzschluss des Keramikkondensators zumindest in eingeschränktem Umfang weiterhin aufrechterhalten werden.

Des Weiteren wird durch die Erfindung die Möglichkeit geschaffen, die Vorrichtung zur Verringerung der Abstrahlung von Funkstörsignalen kostengünstig, platzsparend und fertigungstechnisch gut realisierbar unter Verwendung einer Leiterplatte herzustellen. Dabei kommen ausschließlich Standard-Bauelemente zum Einsatz, die von verschiedenen Herstellern und in großer Stückzahl am Markt erhältlich sind. Ein gemäß der Erfindung verwendeter SMD-Widerstand weist eine geringe Serieninduktivität auf, was sich bezüglich des EMV-Verhaltens der gesamten Vorrichtung positiv auswirkt.

Vorzugsweise wird eine Vorrichtung gemäß der Erfindung im Zusammenhang mit einem Kraftfahrzeug-Steuergerät verwendet und ist zwischen einer Spannungsversorgung und dem Steuergerät positioniert. Die Vorrichtung gemäß der Erfindung kann Bestandteil der Leiterplatte des Steuergerätes sein. Dadurch wird der Platzbedarf der Gesamtvorrichtung gering gehalten.

Weitere vorteilhafte Eigenschaften der Erfindung ergeben sich aus der nachfolgenden beispielhaften Erläuterung anhand der Zeichnung.

### Zeichnung

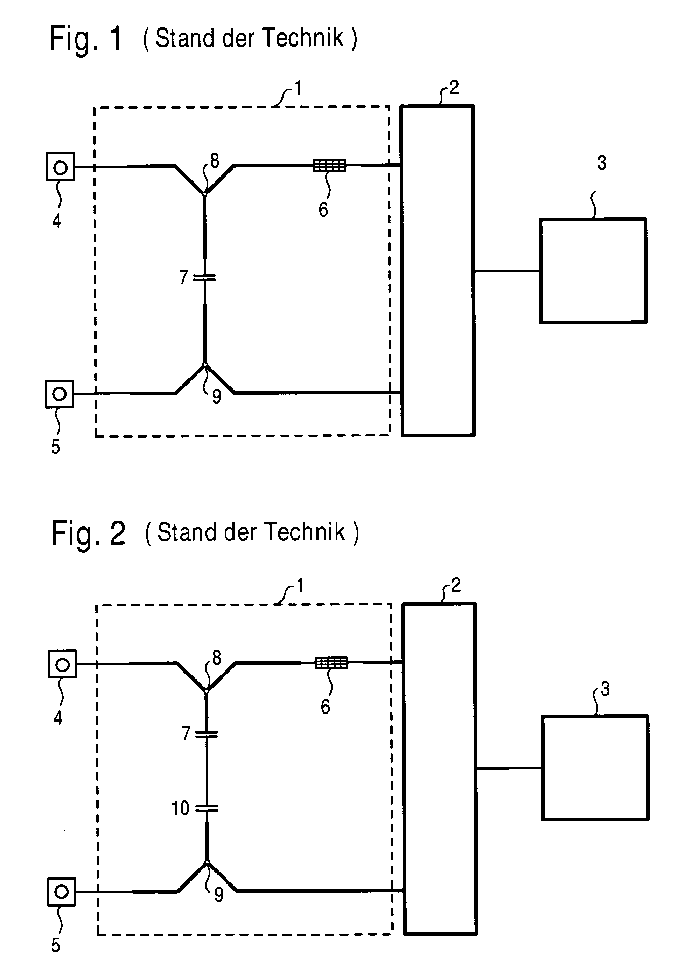

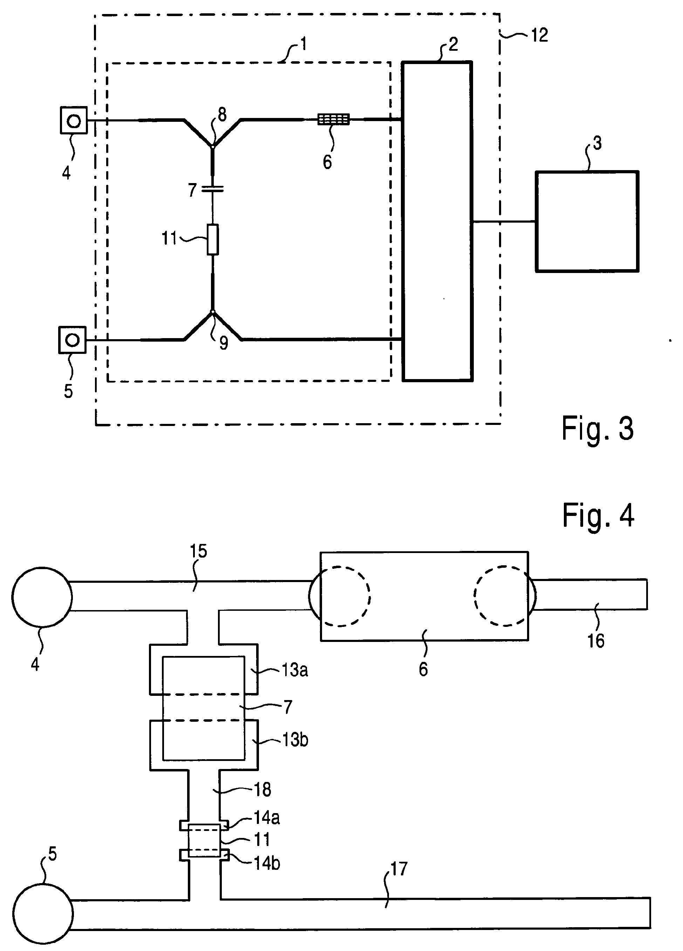

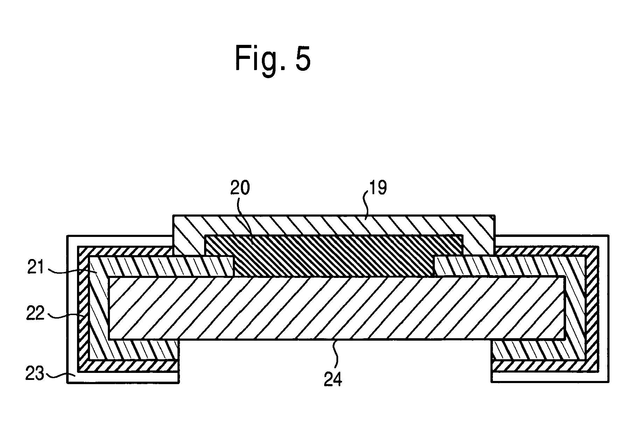

Die Figur 1 zeigt eine Vorrichtung zur Verringerung der Abstrahlung von Funkstörsignalen gemäß dem Stand der Technik. Die Figur 2 zeigt eine weitere Vorrichtung zur Verringerung der Abstrahlung von Funkstörsignalen gemäß dem Stand der Technik. Die Figur 3 zeigt eine Vorrichtung zur Verringerung der Abstrahlung von Funkstörsignalen gemäß der Erfindung. Die Figur 4 veranschaulicht ein Ausführungsbeispiel für eine Realisierung der Erfindung unter Verwendung einer Leiterplatte. Die Figur 5 zeigt eine Skizze zur Veranschaulichung des Aufbaus eines SMD-Widerstandes, der als Dickschichtwiderstand realisiert ist.

### Beschreibung

Die Figur 1 zeigt eine Vorrichtung 1 zur Verringerung der Abstrahlung von Funkstörsignalen gemäß dem Stand der Technik. Die Vorrichtung 1 ist mit einem Versorgungsspannungsanschluss 4 verbunden, bei dem es sich um die Klemme 15 oder die Klemme 30 eines Kraftfahrzeugbordnetzes handeln kann. Ferner ist die Vorrichtung 1 mit einem Masseanschluss 5 kontaktiert. Ausgangsseitig ist die Vorrichtung 1 mit einem elektronischen Steuergerät 2 verbunden, das zur Steuerung eines Verbrauchers 3 dient. Im Betrieb des Steuergerätes 2 treten Funkstörsignale auf, die mittels der Vorrichtung 1 verringert werden, so dass die Auswirkungen der Funkstörsignale auf andere elektronische Geräte oder elektronische Komponenten des Kraftfahrzeugs innerhalb der zulässigen Grenzen sind.

Die Vorrichtung 1 zur Verringerung der Abstrahlung von Funkstörsignalen weist einen Keramikkondensator 7 auf, der zwischen den Versorgungsspannungsanschluss 4 und den Masseanschluss 5 geschaltet ist. Der Keramikkondensator 7 kann in SMD-Bauform realisiert sein. Der masseferne Anschluss des Keramikkondensators 7 ist über einen Knotenpunkt 8 und eine Drossel 6 mit einem Eingang des elektronischen Steuergerätes 2 verbunden. Der andere Anschluss des Keramikkondensators 7 ist über einen Knotenpunkt 9 mit dem Masseanschluss des Steuergerätes 2 verbunden.

Tritt aufgrund einer starken mechanischen Belastung des Keramikkondensators 7 bzw. der Vorrichtung 1 beispielsweise aufgrund eines Bruches ein Kurzschluss auf, dann kann dies zu einem dauerhaften Kurzschlussstrom führen, der eine thermische Zerstörung des Steuergerätes 2 zur Folge haben kann.

Die Figur 2 zeigt eine weitere Vorrichtung zur Verringerung der Abstrahlung von Funkstörsignalen gemäß dem Stand der Technik. Diese unterscheidet sich von der in der Figur 1 gezeigten Vorrichtung dadurch, dass zwischen den Knotenpunkten 8 und 9 zwei in Reihe geschaltete Keramikkondensatoren 7 und 10 vorgesehen sind.

Tritt bei dieser Vorrichtung aufgrund einer starken mechanischen Beanspruchung der Keramikkondensatoren 7 und 10 bzw. der Vorrichtung 1 beispielsweise aufgrund eines Bruches bezüglich nur eines der Kondensatoren ein Kurzschluss auf, dann sind die beiden aus der Figur 2 ersichtlichen Anschlüsse des Steuergerätes 2 nach wie vor gleichstrommäßig voneinander entkoppelt, so dass kein Kurzschlussstrom fließt, der zu einer thermischen Zerstörung des Steuergerätes 2 führen könnte.

Ein Nachteil der in der Figur 2 dargestellten Vorrichtung besteht darin, dass die Kapazitätswerte der beiden Kondensatoren größer sein müssen als der Kapazitätswert des in der Figur 1 gezeigten Kondensators, um dieselbe Wirkung erzielen zu können. Dies entspricht einer Verwendung von Kondensatoren mit größeren Abmessungen und damit einem erhöhten Platzbedarf, was nachteilig ist. Weiterhin nimmt durch diese Vergrößerung der Abmessungen der benötigten Kondensatoren das Risiko eines Keramikbruches weiter zu.

Die Figur 3 zeigt eine Vorrichtung zur Verringerung der Abstrahlung von Funkstörsignalen gemäß der Erfindung. Diese unterscheidet sich von der in der Figur 1 dargestellten Vorrichtung dadurch, dass zwischen den beiden Knotenpunkten 8 und 9 eine Reihenschaltung angeordnet ist, die einen Keramikkondensator 7 und einen dazu in Reihe geschalteten SMD-Widerstand 11 enthält. Der Widerstandswert dieses Widerstandes beträgt vorzugsweise 0 Ohm. Wenn die im jeweiligen Einzelfall vorliegende Detailschaltung des elektronischen Steuergerätes dies erlaubt, kann der Widerstandswert des SMD-Widerstandes aber auch größer als 0 Ohm sein.

Die Verwendung eines derartigen SMD-Widerstandes 11 in Reihe zum Keramikkondensator 7 hat den Vorteil, dass im Falle eines Kurzschlusses des Keramikkondensators 7 das resistive Element des SMD-Widerstandes aufgrund der begrenzten Stromtragfähigkeit des SMD-Widerstandes verdampft, so dass der Stromfluss unterbrochen wird und keine thermische Zerstörung des Steuergerätes 2 bzw. von dessen Leiterplatte erfolgen kann. Folglich ist sichergestellt, dass auch nach einem Auftreten eines Kurzschusses des Keramikkondensators 7 die Funktion des Steuergerätes 2 zumindest in eingeschränktem Umfang aufrechterhalten werden kann.

Ein weiterer Vorteil der Erfindung besteht darin, dass bei einem SMD-Widerstand die leitfähige Widerstandsschicht durch eine isolierende Trägerschicht von der Unterseite des SMD-Widerstandes getrennt ist. Durch diesen konstruktiv bedingten Abstand der im Falle eines Kurzschlusses des Keramikkondensators als Hitzequelle wirkenden leitfähigen Widerstandsschicht des SMD-Widerstandes von der Leiterplatte, auf welche der SMD-Widerstand gelötet ist, wird die Leiterplatte zusätzlich vor einer thermischen Zerstörung geschützt. Dies wird anhand der Figuren 4 und 5 näher erläutert.

Die Figur 4 veranschaulicht ein Ausführungsbeispiel für eine Realisierung einer Vorrichtung gemäß der Erfindung unter Verwendung einer Leiterplatte, in welcher Leiterbahnen 15, 16, 17 und 18 verlaufen. Der Versorgungsspannungsanschluss 4 ist über die Leiterbahn 15 mit einer Bestückposition 13a verbunden, die von einem verbreiterten Endbereich der Leiterbahn 15 gebildet wird. Von dieser Bestückposition 13a beabstandet ist eine weitere Bestückposition 13b vorgesehen, die von einem verbreiterten Endbereich der Leiterbahn 18 gebildet wird. Diese Bestückpositionen 13a und 13b sind zur Aufnahme des in SMD-Bauform realisierten Keramikkondensators 7 vorgesehen, dessen Kontaktanschlüsse bzw. Kontaktschichten auf die genannten Bestückpositionen gelötet werden.

Die Leiterbahn 18 weist einen weiteren verbreiterten Endbereich auf, der eine weitere Bestückposition 14a bildet. Von dieser weiteren Bestückposition beabstandet ist eine Bestückposition 14b vorgesehen, die in einem Endbereich der Leiterbahn 17 vorgesehen ist. Ein anderer Endbereich der Leiterbahn 17 ist mit dem Masseanschluss 5 kontaktiert. Die Bestückpositionen 14a und 14b sind zur Aufnahme des in SMD-Bauform realisierten Widerstandes 11 vorgesehen, dessen Kontaktanschlüsse auf die genannten Bestückpositionen gelötet werden.

In der Figur 4 ist durch die Abmessungen der Bestückpositionen 13a, 13b bzw. 14a, 14b und die Abmessungen der Bauteile 7 und 11 veranschaulicht, dass der SMD-Widerstand 11 wesentlich weniger Platz benötigt als der Keramikkondensator 7.

Die Leiterbahn 15 weist einen weiteren Anschluss auf, an welchem ein Anschluss der Drossel 6 befestigt ist. Der andere Anschluss der Drossel 6 ist mit einem Anschluss der weiteren Leiterbahn 16 kontaktiert.

Die Leiterbahnen 15, 16, 17, 18 können Bestandteil einer Leiterplatte sein, die ausschließlich der Vorrichtung 1 zugehörig ist. Alternativ dazu können die Leiterbahnen 15, 16, 17, 18 aber auch Bestandteil einer Leitplatte sein, die die Elektronik des Steuergerätes 2 trägt, so dass die Vorrichtung 1 zur Verringerung der Abstrahlung von Funkstörsignalen und das elektronische Steuergerät 2 eine bauliche Einheit 12 bilden, wie sie durch die strichpunktierte Linie in der Figur 3 angedeutet ist. Da der SMD-Widerstand 11 nur wenig zusätzlichen Platz benötigt, erfordert die in der Figur 3 dargestellte Vorrichtung 1 nur unwesentlich mehr Platz als die in der Figur 1 dargestellte bekannte Vorrichtung.

Eine Vorrichtung gemäß der Erfindung verwendet ausschließlich Standard-Bauelemente, die von verschiedenen Herstellern und in großer Stückzahl am Markt erhältlich sind. Weiterhin weist der gemäß der Erfindung verwendete SMD-Widerstand 11 nur eine geringe Serieninduktivität auf, was sich bezüglich des EMV-Verhaltens positiv auswirkt.

Die Figur 5 zeigt eine Skizze zur Veranschaulichung des Aufbaus eines als Dickschichtwiderstand realisierten SMD-Widerstandes, wie er bei der Erfindung verwendet werden kann. Aus der dargestellten Querschnittsdarstellung ist ersichtlich, dass die leitfähige Widerstandsschicht 20 des SMD-Widerstandes durch eine elektrisch isolierende Trägerschicht 24, bei der es sich beispielsweise um ein Aluminiumsubstrat handelt, von der Unterseite des SMD-Widerstandes, die auf die nicht gezeichnete Leiterplatte gelötet ist, beabstandet ist. Aufgrund dieses Abstandes der leitfähigen Widerstandsschicht 20, die im Falle eines Kurzschlusses des Keramikkondensators als Hitzequelle wirkt, von der Leiterplatte ist diese vor einer Zerstörung zusätzlich geschützt.

Wie aus der Figur 5 weiterhin hervorgeht, wird die leitfähige Widerstandsschicht 20 von einem Schutzlack 19 überdeckt. Ferner weist der gezeigte SMD-Widerstand mehrere Kontaktschichten 21, 22, 23 auf, die aus verschiedenen Materialien bestehen und die nötige Kontaktierung der Widerstandsschicht 20 über Lötverbindungen mit den zugehörigen Leiterbahnen der Leiterplatte sicherstellen.

Gemäß der vorliegenden Erfindung weist eine Vorrichtung zur Verringerung der Abstrahlung von Funkstörsignalen eine Reihenschaltung eines Keramikkondensators mit einem SMD-Widerstand auf. Im Falle eines Kurzschlusses des Keramikkondensators verdampft die leitfähige Widerstandsschicht des SMD-Widerstandes, so dass kein dauerhafter Kurzschlussstrom fließt, der zu einer thermischen Zerstörung eines angeschlossen elektronischen Gerätes führen könnte. Der SMD-Widerstand wirkt folglich als Sicherungselement, das beim Vorliegen eines Kurzschlusses des Keramikkondensators anspricht.

Bezugszeichenliste
- 1: Vorrichtung zur Verringerung der Abstrahlung von Funkstörsignalen
- 2: Elektronisches Steuergerät
- 3: Verbraucher
- 4: Versorgungsspannungsanschluss
- 5: Masseanschluss
- 6: Drossel
- 7: Keramikkondensator
- 8: Schaltungsknoten
- 9: Schaltungsknoten
- 10: Keramikkondensator
- 11: SMD-Widerstand
- 12: Bauliche Einheit
- 13a,b: Bestückpositionen
- 14a,b: Bestückpostionen
- 15: Leiterbahn
- 16: Leiterbahn
- 17: Leiterbahn
- 18: Leiterbahn
- 19: Schutzlack
- 20: leitfähige Widerstandsschicht
- 21: Kontaktschicht
- 22: Kontaktschicht
- 23: Kontaktschicht
- 24: Trägerschicht

## Patentansprüche

1. Vorrichtung zur Verringerung der Abstrahlung von Funkstörsignalen, welche einen Keramikkondensator (7) und einen mit diesem in Reihe geschalteten SMD-Widerstand (11) aus einer leitfähigen Widerstandsschicht aufweist, wobei die leitfähige Widerstandsschicht so ausgestaltet ist, dass sie im Falle eines Kurzschlusses des Keramikkondensators (11) verdampft.

2. Vorrichtung nach Anspruch 1, worin die Reihenschaltung des Keramikkondensators (7) mit dem SMD-Widerstand (11) zwischen einem Versorgungsspannungsanschluss (4) und einem Masseanschluss (5) angeordnet ist.

3. Vorrichtung nach Anspruch 1 oder 2, worin der Keramikkondensator (7) ein SMD-Bauelement ist.

4. Vorrichtung nach einem der vorhergehenden Ansprüche, worin der Widerstandswert des SMD-Widerstandes (11) 0 Ohm beträgt.

5. Vorrichtung nach einem der Ansprüche 1-3, worin der Widerstandswert des SMD-Widerstandes (11) größer ist als 0 Ohm.

6. Vorrichtung nach einem der vorhergehenden Ansprüche, worin sie Leiterbahnen (15, 16, 17, 18) aufweist, welche Bestandteile einer Leiterplatte sind, dass die Leiterbahnen Bestückpositionen (13a, 13b, 14a, 14b) aufweisen und dass der Keramikkondensator (7) auf erste Bestückpositionen (13a, 13b) und der SMD-Widerstand (11) auf zweite Bestückpositionen (14a, 14b) gelötet ist.

7. Vorrichtung nach einem der vorhergehenden Ansprüche, worin sie einem elektronischen Steuergerät (2) vorgeschaltet ist.

8. Vorrichtung nach Anspruch 7, worin der masseferne Anschluss des Keramikkondensators (7) über eine Drossel (6) mit dem Steuergerät (2) verbunden ist.

9. Vorrichtung nach Anspruch 7 oder 8, worin das elektronische Steuergerät (2) eine Leiterplatte aufweist und dass die Leiterbahnen (15, 16, 17, 18) Bestandteil der Leiterplatte des elektronischen Steuergerätes (2) sind.

## Claims

1. Device for reducing the emission of radio interference signals, having a ceramic capacitor (7) and an SMD resistor (11) composed of a conductive resistive layer, said SMD resistor being connected in series with said ceramic capacitor, wherein the conductive resistive layer is configured in such a way that it evaporates in the case of a short circuit of the ceramic capacitor (11).

2. Device according to Claim 1, wherein the series circuit comprising the ceramic capacitor (7) with the SMD resistor (11) is arranged between a supply voltage terminal (4) and an earth terminal (5).

3. Device according to Claim 1 or 2, wherein the ceramic capacitor (7) is an SMD component.

4. Device according to any of the preceding claims, wherein the resistance value of the SMD resistor (11) is 0 ohms.

5. Device according to any of Claims 1 - 3, wherein the resistance value of the SMD resistor (11) is greater than 0 ohms.

6. Device according to any of the preceding claims, wherein it has conductor tracks (15, 16, 17, 18) that are parts of a printed circuit board, wherein the conductor tracks have placement positions (13a, 13b, 14a, 14b), and wherein the ceramic capacitor (7) is soldered onto first placement positions (13a, 13b) and the SMD resistor (11) is soldered onto second placement positions (14a, 14b).

7. Device according to any of the preceding claims, wherein it is connected upstream of an electronic control unit (2).

8. Device according to Claim 7, wherein that terminal of the ceramic capacitor (7) which is remote from earth is connected to the control unit (2) via an inductor (6).

9. Device according to Claim 7 or 8, wherein the electronic control unit (2) has a printed circuit board, and wherein the conductor tracks (15, 16, 17, 18) are part of the printed circuit board of the electronic control unit (2).

## Revendications

1. Dispositif pour réduire le rayonnement de signaux radio parasites émis par un condensateur en céramique (7) et une résistance SMD (11) branchée en série sur le condensateur et constituée par une couche résistante conductrice,
la couche résistante conductrice étant réalisée de façon à se vaporiser en cas de court-circuit du condensateur en céramique (11).

2. Dispositif selon la revendication 1,
selon lequel
le montage en série du condensateur en céramique (7) et de la résistance SMD (11) est prévu entre le branchement de tension d'alimentation (4) et le branchement de masse (5).

3. Dispositif selon la revendication 1 ou 2,
selon lequel
le condensateur en céramique (7) est un composant SMD (composant monté en surface).

4. Dispositif selon les revendications précédentes,
selon lequel
la valeur de la résistance SMD (11) est égale à 0 Ohm.

5. Dispositif selon les revendications 1 à 3,
selon lequel
la valeur de la résistance SMD (11) est supérieure à 0 Ohm.

6. Dispositif selon les revendications précédentes,
selon lequel
il comporte des chemins conducteurs (15, 16, 17, 18) faisant partie d'une plaque de circuit,
les chemins conducteurs ayant des positions de garnissage (13a, 13b, 14a, 14b), et
le condensateur en céramique (7) est soudé sur les premières positions de garnissage (13a, 13b) et la résistance SMD (11) est soudée sur les secondes positions de garnissage (14a, 14b).

7. Dispositif selon les revendications précédentes,
selon lequel
il est monté en amont dans l'appareil de commande électronique (2).

8. Dispositif selon la revendication 7,
selon lequel
le branchement non relié à la masse du condensateur en céramique (7) est relié à l'appareil de commande (2) par l'intermédiaire d'une bobine (6).

9. Dispositif selon la revendication 7 ou 8,
selon lequel
l'appareil de commande électronique (2) comporte une plaque de circuit et les chemins conducteurs (15, 16, 17, 18) font partie de la plaque de circuit de l'appareil de commande électronique (2).
